**Europäisches Patentamt**

**European Patent Office**

**Office européen des brevets**

(19)

(11) Veröffentlichungsnummer: **0 069 398**
B1

(12) # EUROPÄISCHE PATENTSCHRIFT

(45) Veröffentlichungstag der Patentschrift:
**02.04.86**

(21) Anmeldenummer: **82106087.8**

(22) Anmeldetag: **07.07.82**

(51) Int. Cl.⁴: **G 01 R 31/28,** H 04 J 3/14,
H 03 M 13/00

(54) **Verfahren zur Prüfung von Analog-Digital-Wandlern und/oder von Digital-Analog-Wandlern oder von nachrichtentechnischen Übertragungsabschnitten, die solche Wandler enthalten oder mit ihnen in Reihe geschaltet sind, insbesondere zur Prüfung von Codecs für PCM-Geräte, sowie Vorrichtung zur Durchführung des Verfahrens.**

(30) Priorität: **08.07.81 DE 3126939**
**13.05.82 DE 3218066**

(43) Veröffentlichungstag der Anmeldung:
**12.01.83 Patentblatt 83/2**

(45) Bekanntmachung des Hinweises auf die Patenterteilung:
**02.04.86 Patentblatt 86/14**

(84) Benannte Vertragsstaaten:
**AT DE FR GB IT NL SE**

(73) Patentinhaber: **Siemens Aktiengesellschaft, Berlin und München Wittelsbacherplatz 2, D-8000 München 2 (DE)**

(72) Erfinder: **Hahn, Helmuth, Ing.grad., Steinberg 4, D-8021 Hohenschäftlarn (DE)**
Erfinder: **Cordt, Werner, Ing.grad., Brehmstrasse 9, D-8000 München 5 (DE)**
Erfinder: **Borm, Winfried, Ing.grad., Karl-Marx-Ring 31, D-8000 München 83 (DE)**

(56) Entgegenhaltungen:
DE - A - 2 503 974
DE - A - 2 804 951

TECHNISCHES MESSEN, Band 48, Nr. 10, Oktober 1981, Seiten 333-337, München (DE); R. FRITZ et al.: "Test von Analog/Digital-Umsetzern mit Hilfe eines Logik-Analysators".
ELEKTRONIK, Band 27, Nr. 4, April 1978, Seiten 97-101; GÜNTER PRETZL: "Die Prüfung des dynamischen Verhaltens schneller A/D-Umsetzer".
ELEKTRONIK, Band 24, Nr. 12, Dezember 1975, Seiten 56-60; R.GÖSSLER: "Prüfmethoden für A/D-Umsetzer".
ELEKTRONIK, Band 28, Nr. 20, Oktober 1979, Seiten 61-66; M. ZIMMER: "Testen schneller

(56) Entgegenhaltungen: (Fortsetzung)
Analog/Digital-Umsetzer mit log/Digital-Umsetzer mit Tischrechnern".
RADIOFERNSEHEN ELEKTRON, Band 27, Nr. 7, Juli 1978, Seiten 425-427; B. SCHILDWACH et al.: "Abgleich und Prüfung von Analog-Digital-und Digital-Analog-Umsetzern".
THE RADIO AND ELECTRONIC ENGINEER, Band 50, Nr. 7, Juli 1980, Seiten 353-362, London (GB); R.G. ROLLS: "A review of distortion and its measurement in p.c.m. telephony systems".
FREQUENZ, Band 28, Nr. 10, 1974, Seiten 270-274; H. FREYTAG: "Messgeräte für PCM-Digital-Übertragungssysteme".

## Beschreibung

Die Erfindung betrifft ein Verfahren der im Gattungsbegriff des Patentanspruches 1 beschriebenen Art sowie eine Vorrichtung zur Durchführung des Verfahrens.

Die bekannten Vorteile der digitalen Nachrichtenübertragung und -vermittlung, zu denen beispielsweise die beliebige Regenerierbarkeit der Signale, die Möglichkeit ihrer Be- und Verarbeitung mit den Mitteln der modernen Computertechnologie sowie die Verfügbarkeit hochentwickelter und preiswerter Digitalbausteine, aber auch die wesentliche Strukturvereinfachung vermittlungstechnischer Anlagen gehören, haben zu der allenthalben zu beobachtenden Einführung digitaler Nachrichtensysteme geführt. Die neuerdings gegebene Verfügbarkeit ausserordentlich breitbandiger Übertragungskanäle in Form von Lichtwellenleitern kommt der Tendenz zur Digitalisierung des elektrischen Nachrichtenwesens entgegen.

Da die Originalinformationen in den meisten Fällen, z.B. in der Fernsprechtechnik und bei der Bildübertragung von Halbtonvorlagen, analoge Grössen sind, müssen sie mit Hilfe geeigneter Anpassungseinrichtungen in digitale Signale umgewandelt werden. Diese Anpassungseinrichtungen, die an den Eingängen der Systeme die Analog-Digital-Wandlung und an ihren Ausgängen die Digital-Analog-Wandlung auszuführen haben, sind derzeit die problematischsten Bausteine der digitalen Nachrichtensysteme. Dies betrifft sowohl ihre Funktion als auch den von ihnen innerhalb eines Systems verkörperten gerätetechnischen Aufwand, der z.B. bei digitalen Fernsprechvermittlungsanlagen etwa die Hälfte des gesamten Hardware-Aufwandes ausmacht. Es ist offensichtlich, dass jeder Fortschritt in der Entwicklung und Herstellung kostengünstiger Wandlerbausteine, die den gestellten strengen Anforderungen genügen, die Wirtschaftlichkeit des Gesamtsystems positiv beeinflusst.

Aus diesen Gründen kommt der Prüfung der im allgemeinen als mikroelektronische Schaltungen realisierten Analog-Digital- und/oder Digital-Analog-Wandler bzw. der diese Wandler enthaltenden Bausteine eine besondere Bedeutung zu. Die Prüfung soll nicht nur genauen Aufschluss über die Qualifikation des jeweils geprüften Exemplares geben sondern auch Rückschlüsse auf systematische Fertigungsmängel zulassen.

Die Prüfung digitaler Wandlerbausteine mit Hilfe herkömmlicher Übertragungsmessplätze erfordert vergleichsweise lange Mess- und Prüfzeit, die unter anderem von dem Einschwingverhalten der vorhandenen Filter abhängig ist, so dass insbesondere die Messung der Quantisierungsverzerrung relativ aufwendig ist.

Es sind Prüfeinrichtungen bekannt («Fairchild Telecom Test Adapter», Prospekt 11/80 10 M 129000), bei denen die durch die zeitdiskrete Abtastung gewonnenen Signalproben einer schnellen Fourier-Transformation unterworfen und dadurch aus dem Zeitbereich in den Frequenzbereich versetzt werden, so dass zur weiteren Untersuchung die spektralen Komponenten zur Verfügung stehen. Die Untersuchung der Signalproben erfolgt mit geeigneten mathematischen Verfahren durch einen Rechner.

Andere moderne Verfahren zur Prüfung von Wandlerbausteinen sind in der Zeitschrift «Der Elektroniker», 6–181, Seite 56 bis 58 und in dem Aufsatz «An Integrated analog/digital Test System, 1981 Proceedings Electronic Components Conference» S. 202–206 und «Real Time Measuring Method for CODEC Characteristics Using Digital Signal Processing», FUJITSU Scientific & Technical Journal Juni 1981, S. 15–33 beschrieben.

Ein Verfahren mit den Merkmalen des Gattungsbegriffs des Patentanspruches 1 ist durch den Aufsatz «Die Prüfung des dynamischen Verhaltens schneller A/D-Umsetzer», ELECTRONIC 1978, Heft 4, Seiten 97–101 bekannt. Bei diesem bekannten Verfahren wird als Messsignal eine Dreieck-Prüfspannung variabler Frequenz verwendet. Bei der Auswertung machte man sich die Tatsache zunutze, dass in einem solchen dreieckförmigen Signal alle möglichen Pegel mit gleicher Wahrscheinlichkeit auftreten. Falls der Prüfling ideales Verhalten zeigt, treten auch die einzelnen Codeworte mit gleicher Wahrscheinlichkeit, d.h. in gleicher Anzahl, auf. Wenn dies nicht der Fall ist, lassen sich entsprechende Rückschlüsse auf das Verhalten des Prüflings ziehen. Durch Steigerung der Frequenz des dreieckförmigen Messsignals vergrössert sich die als «Slow-Rate» bezeichnete Anstiegs- und Abfallsgeschwindigkeit des Signals. Wenn nun die einzelnen Codeworte am Ausgang des Prüflings nicht mehr mit gleicher Häufigkeit auftreten, lassen sich entsprechende Rückschlüsse auf die «Geschwindigkeit» des Prüflings ziehen. Bei diesem bekannten Verfahren sind das Eingangssignal und der Abtastwert nicht synchronisiert, so dass eine exakte Zuordnung eines Codewortes und des entsprechenden Analogwertes nicht möglich ist. Somit ist dieses bekannte Verfahren letztlich ein statistisches Verfahren, bei welchem der Zusammenhang zwischen Eingangs- und Ausgangssignalen des Prüflings durch Wahrscheinlichkeiten bestimmt ist.

Das Verfahren gemäss der Erfindung ist durch die im Patentanspruch 1 beschriebenen Verfahrensschritte gekennzeichnet.

Vorrichtungen zur Durchführung dieses Verfahrens werden durch die Merkmale der Ansprüche 11 und 12 beschrieben.

Vorteilhafte Ausgestaltungen des Verfahrens gemäss der Erfindung sowie der Vorrichtungen zur Durchführung dieses Verfahrens sind Gegenstand der Unteransprüche, auf die hiermit zur Verkürzung der Beschreibung ausdrücklich verwiesen wird.

Obwohl es bei dem Verfahren gemäss der Erfindung grundsätzlich möglich ist, mit einer einzigen Pegeleinstellung, die sich z.B. über den gesamten Aussteuerungsbereich des Prüflings erstreckt und mit einer einzigen Messfrequenz, die den im kennzeichnenden Teil des Patentanspruches 1 genannten Bedingungen entspricht, zu arbeiten, kann es zur Untersuchung bestimmter interessierender Quantisierungsbereiche und -stufen vorteilhaft sein, sinusförmige Messsignale unterschiedlicher Amplitude zu verwenden.

Die Beaufschlagung des Prüflings mit dem Messsignal, dessen Frequenz der im Patentanspruch 1 angegebenen Beziehung entspricht, liefert während des vorgesehenen Prüfzeitraumes Signalproben, die sämtlich unterschiedlichen Argumentwerten des Messsignals entsprechen. Diese lassen sich durch geeignete Sortierung zu einer Abbildung zusammensetzen, die einer gewissermassen «stroboskopischen» Darstellung der Antwort des Prüflings auf das Messsignal entspricht. Das Verfahren ermöglicht beliebig grosse Auflösung in den interessierenden Aussteuerungsbereichen, z.B. in der Nähe des Nulldurchganges. Im Gegensatz zu bekannten Verfahren, die sich der schnellen Fourier-Transformation bedienen, ermöglicht das Verfahren gemäss der Erfindung nicht nur eine pauschale Beschreibung der Wandlerkennlinie sondern deren genaue Rekonstruktion. Da alle Messwerte im eingeschwungenen Zustand des Prüflings gewonnen werden, müssen keine Einschwingzeiten gegebenenfalls vorhandener frequenzabhängiger Bauelemente abgewartet werden.

Das Verfahren gemäss der Erfindung ermöglicht – wie erwähnt – eine beliebig genaue Rekonstruktion der tatsächlichen Übertragungskennlinie des jeweiligen Prüflings. Die einzelnen Quantisierungsstufen dieser Übertragungskennlinie können durch einfache Regressionsrechnung aus den ermittelten Wertepaaren (Analogwert und zugehöriger Digitalwert) bestimmt werden. Vorteilhafterweise werden so viele Messwerte vorgesehen, dass für jede Quantisierungsstufe z.B. zehn Wertepaare zur Verfügung stehen.

Mit Hilfe der aus den Messwerten ermittelten Übertragungskennlinie lassen sich alle interessierenden Parameter des Prüflings, z.B. die pegelabhängige Dämpfungsverzerrung und die pegelabhängige Quantisierungsverzerrung bestimmen.

Im allgemeinen wird man die pegelabhängige Dämpfungsverzerrung und die pegelabhängige Quantisierungsverzerrung für sinusförmige Signale ermitteln, da die Feinstruktur der betreffenden Kurven eine besonders genaue Analyse der Qualität des Prüflings und seiner Schwächen ermöglicht. Es ist im Rahmen des Verfahrens gemäss der Erfindung jedoch auch möglich, die genannten pegelabhängigen Verzerrungen auch für Rauschsignale zu berechnen, so dass Vergleichbarkeit mit anderen Verfahren zur Verzerrungsmessung gegeben ist.

Das Verfahren gemäss der Erfindung ermöglicht die Prüfung nicht nur der eigentlichen Wandler sondern auch der mit ihnen verbundenen Übertragungselemente oder -abschnitte. Das können entweder die mit dem eigentlichen Wandler verbundenen bzw. nicht getrennt zugänglichen Filter sein oder aber auch ganze Leitungsabschnitte oder dergleichen. Die Wandler können entweder in Kombination mit derartigen Übertragungsabschnitten geprüft werden, so dass sich das Verhalten der aus Wandler und beispielsweise Leitungsabschnitt bestehenden Gesamtanordnung ermitteln lässt, oder aber es können die Eigenschaften von Übertragungsabschnitten oder allgemein von Vierpolen für sich ermittelt werden, wenn diese mit einem Wandler kombiniert sind, dessen Eigenschaften zuvor separat durch das Verfahren gemäss der Erfindung ermittelt worden sind (Normwandler).

Die periodische Messspannung, deren Frequenz im Vergleich zur Abtastrate des digitalen Systems so gewählt ist, dass die Abtastproben – bezogen auf das Periodizitätsintervall der Messspannung – sämtlich zu unterschiedlichen Argumentwerten gehören, so dass sie in ihrer Gesamtheit die Antwort des Wandlers repräsentieren, kann grundsätzlich beliebigen zeitlichen Verlauf haben, wenn nur sichergestellt ist, dass alle interessierenden Auslenkungswerte (Amplituden) in ihm auftreten. So bietet sich z.B. ein Dreiecksignal an, welches monoton bis zu einem z.B. der Aussteuerungsgrenze des Prüflings entsprechenden Spitzenwert ansteigt. Dass in der Praxis einem sinusförmigen Messsignal der Vorzug zu geben ist, hat vor allem zwei Gründe: Zum einen lässt sich ein sinusförmiges Signal über die erforderliche Periodenzahl sehr genau realisieren, zum anderen kann ein sinusförmiges Signal die mit dem Wandler kombinierten frequenzabhängigen Bauteile, z.B. Filter, passieren wenn es innerhalb des von dem Wandler zu verarbeitenden Frequenzbandes liegt.

Im folgenden sei die Erfindung anhand der Zeichnungen näher erläutert:

Fig. 1 zeigt das Blockschaltbild einer Anordnung zur Messung eines Prüflings in Analog-Digital-Richtung,

Fig. 2 zeigt das Blockschaltbild einer Anordnung zur Messung eines Prüflings in Digital-Analog-Richtung,

Fig. 3 zeigt das Blockschaltbild einer Anordnung zur Erzeugung eines Messsignals mit definierter Frequenz- und Phasenlage,

Fig. 4 zeigt das Blockschaltbild einer Anordnung zur Messung eines Prüflings in Analog-Digital-Richtung und umgekehrt,

Fig. 5 zeigt schematisch den zeitlichen Verlauf einiger Perioden eines Messsignals sowie die relative Lage der Abtastzeitpunkte,

Fig. 6 zeigt eine durch zeitrichtige Zusammensetzung der Abtastproben aus Fig. 5 gewonnene Hüllkurve der dem Messsignal entsprechenden Antwort des Prüflings,

Fig. 7 bis 13 zeigen Kurven und Diagramme, die mit Hilfe des Verfahrens gemäss der Erfindung für einen Analog-Digital-Wandler gewonnen wurden. Im einzelnen zeigen

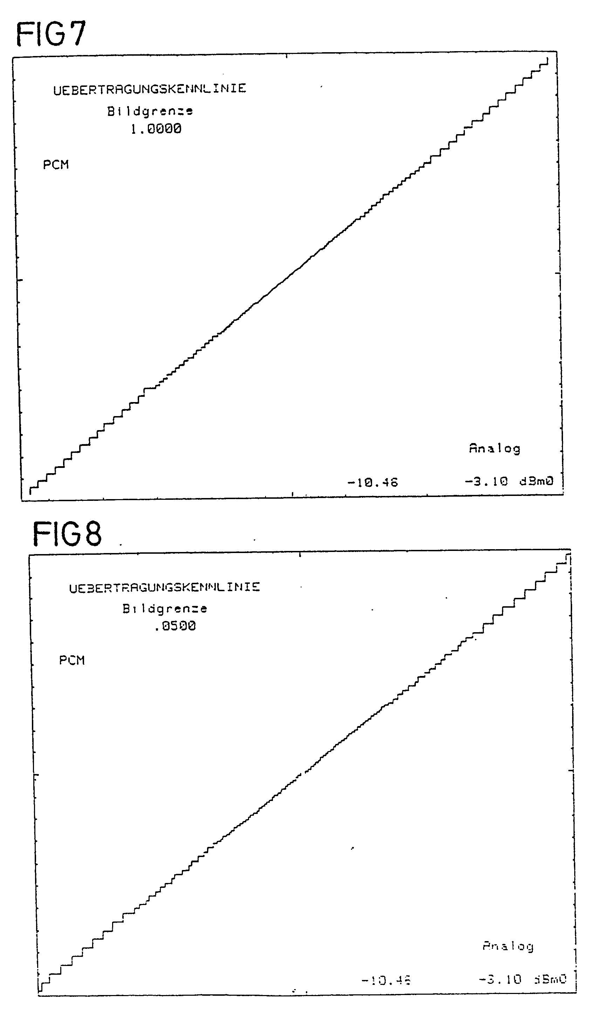

Fig. 7 die Übertragungskennlinie des Prüflings,

Fig. 8 einen Ausschnitt der Übertragungskennlinie gemäss Fig. 7 in vergrössertem Massstab,

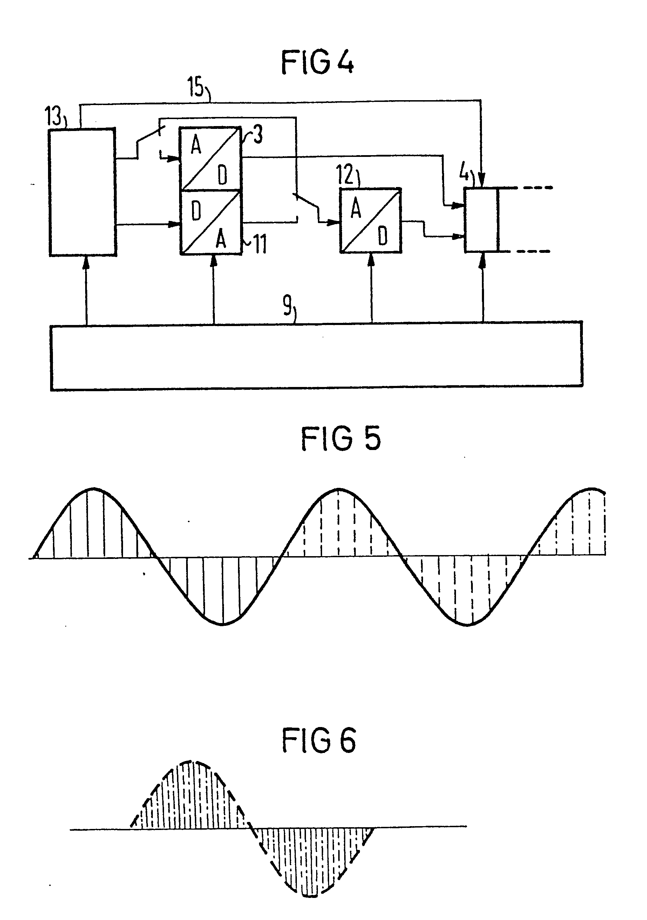

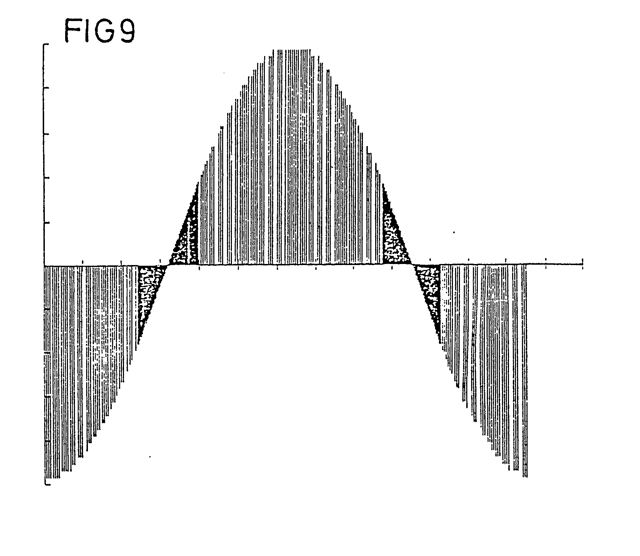

Fig. 9 eine der Darstellung gemäss Fig. 6 entsprechende Darstellung der digitalisierten und dekodierten Antwort des Prüflings auf das sinusförmige Messsignal,

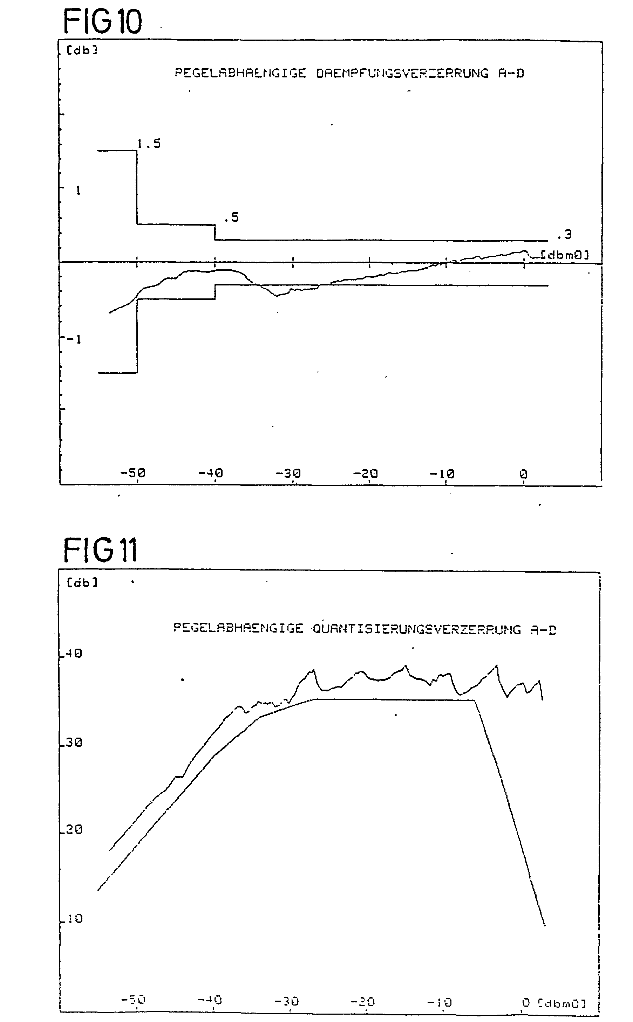

Fig. 10 die pegelabhängige Dämpfungsverzerrung bei sinusförmigem Signal,

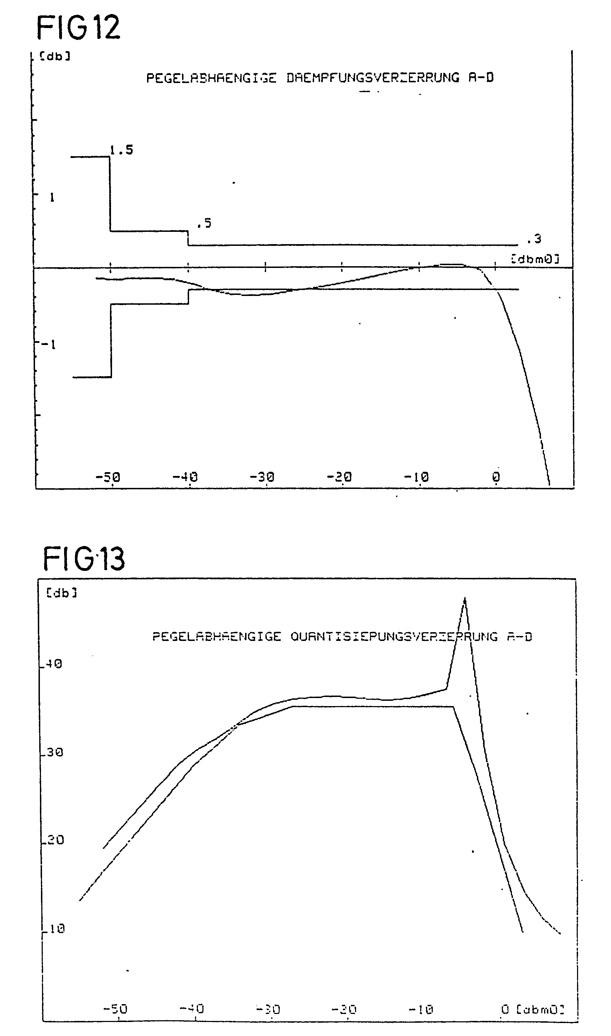

Fig. 11 die pegelabhängige Quantisierungsverzerrung für ein sinusförmiges Signal,

Fig. 12 die pegelabhängige Dämpfungsverzerrung für ein Rauschsignal und

Fig. 13 die pegelabhängige Quantisierungsverzerrung für ein Rauschsignal.

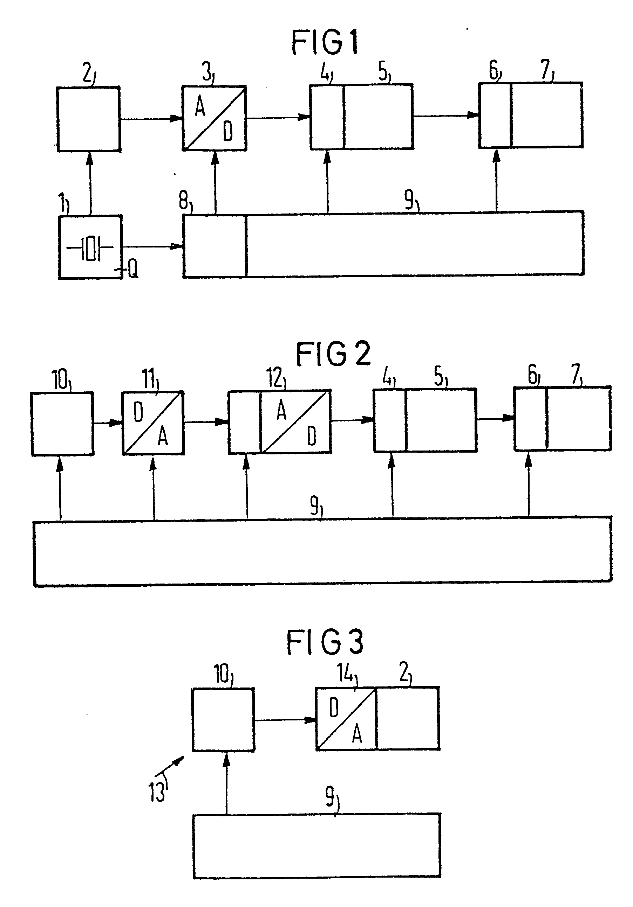

Die in Fig. 1 dargestellte Messanordnung beinhaltet einen durch einen Quarz Q gesteuerten Generator 1 zur Erzeugung eines Signals vorgegebener Frequenz, aus welchem in dem Signalgenerator 2 das eigentliche Messsignal abgeleitet wird. Der Ausgang des Signalgenerators 2 ist mit dem Analog-Eingang des mit 3 bezeichneten Prüflings verbunden. Der Digital-Ausgang des Prüflings 3 steht über einen Serien-Parallel-Wandler 4 mit einem Speicher 5 in Verbindung. Letzterer ist mit einem Interface 6 verbunden, über welches ein Rechner 7 erreichbar ist. Der Generator 1 steuert ausser dem Signalgenerator 2 einen weiteren Generator 8 zur Erzeugung der Systemabtastimpulse sowie die mit 9 bezeichnete Steuereinrichtung zur taktgerechten Ansteuerung des Serien-Parallel-Wandlers 4 und des Interface 6. Hierdurch ist die Synchronisierung von Messignal, Prüfling und Speicher gewährleistet.

Die aus der Quarzfrequenz abgeleitete Frequenz des Signalgenerators 2 einerseits und die in dem Signalgenerator 8 erzeugte Taktfrequenz andererseits sind so gewählt, dass alle Abtastzeitpunkte, die innerhalb eines sich über eine Vielzahl von Perioden des Messsignals erstreckenden Prüfzeitraumes liegen, relativ zu dem Periodizitätsintervall des Messsignals unterschiedliche Zeitlagen innehaben, d.h. dass jeder Abtastzeitpunkt einem anderen (genau definierten) Argumentwert innerhalb des Periodizitätsintervalls des Messsignals entspricht. Auf diese Weise lassen sich beliebig viele Signalproben gewinnen, die in ihrer Gesamtheit das Verhalten des Prüflings beschreiben. Die diesen Signalproben entsprechenden Digitalwörter werden in dem Speicher 5 abgelegt. Sie stehen somit für eine Weiterverarbeitung durch den Rechner 7 zur Verfügung. Die Signalproben können beispielsweise nach ihrer relativen zeitlichen Lage im Periodizitätsintervall des Messsignals sortiert und zu einer «Hüllkurve» des Messsignals zusammengesetzt werden, da die zugehörigen Argumentwerte (d.h. die Zeitlage im Periodizitätsintervall) genau bekannt sind.

In einer praktisch ausgeführten Messanordnung für PCM-Codecs mit der Systemabtastfrequenz von 8 kHz, einer Abtastperiodendauer von 125 μs, besitzt das Messsignal eine Frequenz von etwa 814 Hz. Damit ergeben sich nach wenig mehr als einer Sekunde etwa 1000 Schwingungen, die jeweils durch etwa 10 Abtastperioden erfasst sind. Alle Signalproben besitzen unterschiedliche relative Zeitlagen im Periodizitätsintervall des Messsignals. Die den Abtastproben entsprechenden Digitalwörter werden – wie erwähnt – über den Serien-Parallel-Wandler 4 in den Speicher 5 gegeben. Die feste und bekannte Zuordnung von Frequenz und Phasenlage des Abtast- und Messignals ermöglicht eine exakte Angabe darüber, an welchem Speicherplatz sich die den einzelnen Werten des Antwortsignals entsprechenden PCM-Wörter befinden.

In Fig. 5 ist die zeitliche Lage der Abtastproben innerhalb verschiedener Perioden des Messsignals angedeutet, wobei die Abtastproben in unterschiedlichen Perioden durch verschiedene Stricharten versinnbildlicht sind.

Aus Fig. 6 ist erkennbar, wie diese Abtastproben, die unterschiedlichen Perioden des Messsignals angehören, zeitgerecht, d.h. mit dem ihnen entsprechenden Argumentwert, zu der erwähnten Hüllkurve zusammengesetzt sind. Zu diesem Zweck werden die einzelnen PCM-Wörter mittels eines geeigneten Programms aus dem Speicher 5 ausgelesen und sortiert. Fig. 9 zeigt ein der Fig. 6 entsprechendes mit Hilfe eines Plotters erstelltes Diagramm, das die Antwort eines realen Codecs auf das sinusförmige Messsignal wiedergibt.

Fig. 7 und 8 zeigen die ebenfalls mit Hilfe eines Plotters erstellten Übertragungskennlinien des Codecs, die aus der Zuordnung der digitalen Antwortsignale auf die in der oben beschriebenen Weise erzeugten Abtastproben des Messsignals ermittelt wurden. Auf der Abszissenachse ist das analoge Eingangssignal des Prüflings aufgetragen, während auf der Ordinatenachse das digitale Antwortssignal angegeben ist. Fig. 7 zeigt die Übertragungskennlinie über den gesamten Aussteuerbereich des Codecs, während Fig. 8 einen um den Faktor 20 vergrösserten Ausschnitt wiedergibt. Die unterschiedliche Stufengrösse der einzelnen Quantisierungsintervalle entspricht der (durch einzelne Segmente approximierten) logarithmischen Kompandierungskennlinie des Analog-Digital-Wandlers.

Da der zeitliche Verlauf des von dem Signalgenerator 2 abgegebenen Messsignals und seine mathematische Beschreibung genau bekannt sind, ist die rechnerische Behandlung der von dem Prüfling 3 erzeugten Messwerte, die in dem Speicher 5 abgelegt sind, sehr einfach. Dadurch lassen sich system- und exemplarbedingte Abweichungen zwischen dem gekannten Messsignal und der Antwort des Prüflings, d.h. das Kodierverhalten des Prüflings unter betriebsähnlichen Bedingungen im eingeschwungenen Zustand schnell prüfen, ohne dass – wie bei bekannten Verfahren – ein problematischer Abgleich von Komparatoren o.ä. erforderlich ist. Insbesondere ergeben sich wegen der festen Zuordnung der Messwerte zu den Originalsignalen einfachere Rechenregeln, eine geringere Anzahl von Rechenschritten, exaktere Ergebnisse und wesentlich kürzere Rechenzeiten als bei bekannten Prüfverfahren.

Fig. 10 zeigt in normierter Darstellung die pegelabhängige Dämpfungsverzerrung eines Codecs in Analog-Digital-Richtung für sinusförmige Signale. Die Zeichnung wurde wieder mit Hilfe eines Plotters erstellt. Die in durchgezogenen Linien eingetragenen treppenförmigen Kurven veranschaulichen die Toleranzgrenzen. Es zeigen sich, dass die Dämpfungsverzerrung des gemessenen Prüflings im Pegelbereich von etwa – 30 dbmO ausserhalb des zulässigen Toleranzbereiches liegt.

Es sei noch erwähnt, dass sich bei der Ermittlung der pegelabhängigen Dämpfungsverzerrung die «Entscheidungsschwellen» bei dem Verfahren gemäss der Erfindung sowohl in dem Bereich der positiven als auch der negativen Halbwelle getrennt bewerten lassen. Die dargestellte Kurve entspricht beispielsweise den positiven Halbwellen des Messsignals. Wenn man auch die den negativen Halbwellen entsprechenden Werte auftragen lässt, erhält man zusätzlich eine Kurve, die einer Spiegelung der dargestellten Kurve an der Ordinatenachse entspricht, falls der Prüfling vollkommen «symmetrisch» arbeitet.

Fig. 11 zeigt die pegelabhängige Quantisierungsverzerrung desselben Codecs wiederum in Analog-Digital-Richtung. Dabei ist der Codec wiederum mit einem sinusförmigen Eingangssignal beaufschlagt.

Fig. 12 und 13 zeigen die pegelabhängige Dämpfungsverzerrung bzw. die pegelabhängige Quantisierungsverzerrung wiederum desselben Codecs, diesmal jedoch für Rauschsignale. Man erkennt, dass im Vergleich zu Fig. 10 bzw. 11 die Feinstruktur der Kurven infolge der den Rauschsignalen innewohnenden breiteren Streuung der Wahrscheinlichkeitsverteilung verwischt ist. Obwohl die in Fig. 12 und 13 dargestellten Kurven den Codec ausführlicher «beschreiben» als die entsprechenden Kurven für Rauschsignale, ist es nützlich, auch diese darzustellen, da somit Vergleichsmöglichkeiten gegeben sind mit den Ergebnissen anderer Messverfahren, die ebenfalls mit Rauschsignalen arbeiten.

Die in Fig. 2 dargestellte Anordnung dient zur Messung eines Digital-Analog-Wandlers bzw. eines Codecs in Digital-Analog-Richtung. Es ist ein Digitalwortgenerator 10 vorgesehen, der eine Wortfolge liefert, die beispielsweise den Abtastwerten eines sinusförmigen Messsignals entspricht, dessen Frequenz wieder die gleiche Relation zur Systemabtastfrequenz aufweist wie bei der vorangehenden Beschreibung. Die von dem Generator 10 erzeugte Wortfolge wird dem Digitaleingang des mit 11 bezeichneten Prüflings zugeführt. Dessen Analog-Ausgang steht mit dem Analog-Eingang eines mit 12 bezeichneten Normkodierers in Verbindung. Der Digital-Ausgang des Normkodierers 12 ist – analog zu der Anordnung gemäss Fig. 1 – mit einem Serien-Parallel-Wandler 4 verbunden, dem sich die gleichen Baugruppen bzw. Geräte anschliessen wie bei der Anordnung gemäss Fig. 1. Alle Schaltungsteile stehen wieder gemeinsam unter dem koordinierenden Einfluss einer Steuervorrichtung, die wiederum mit 9 bezeichnet ist. Das Verhalten des Normkodierers 12 wird zweckmässigerweise durch eine Anordnung gemäss Fig. 1 geprüft und gegebenenfalls einer Fehlerkorrektur unterzogen. Fig. 4 zeigt eine entsprechende Anordnung. Der dort in seiner Gesamtheit mit 13 bezeichnete Generator ist in Fig. 3 im einzelnen dargestellt. Er besteht aus einem Digitalwortgenerator 10, der wiederum mit 10 bezeichnet ist und dessen Ausgang zu einem Digital-Analog-Wandler 14 führt, der seinerseits einen Sinusgenerator steuert, der wie in Fig. 1 mit 2 bezeichnet ist. Die in Fig. 3 gezeigte Schaltungsanordnung gewährleistet eine exakte Synchronisation zwischen Messignal und Abtastsignal.

Das (analoge) Ausgangssignal des Generators 10 kann bei der Anordnung gemäss Fig. 4 durch entsprechende Umschalter wahlweise entweder dem Analog-Eingang des Prüflings 3 oder dem Analog-Eingang des Normkodierers 12 zugeführt werden. Auf diese Weise kann letzterer überprüft und einer Fehlerüberwachung unterworfen werden. Eine mit 15 bezeichnete Leitung dient zur Eingabe von Werten des Digitalwortgenerators zum Zwecke der Fehlerkorrektur. Zur Fehlereliminierung können die Werte mit einer berechneten Idealkurve in Beziehung gesetzt werden.

Im folgenden sei die Funktionsweise der Anordnung gemäss Fig. 4 kurz angedeutet:

Mit der gezeigten Schalterstellung dient die Anordnung zur Überprüfung des Normkodierers 12. Er wird ebenso behandelt wie der Prüfling 3 in der Anordnung gemäss Fig. 1. Das Ergebnis dieser Prüfung ist gegebenenfalls Anlass zu einer Korrektur.

Wenn der mit dem Analog-Eingang des Normkodierers 12 verbundene Umschalter betätigt wird, entspricht die Anordnung in ihrer Wirkungsweise derjenigen von Fig. 2. Tiefpass und sin x/x-Entzerrer, die zwischen Prüfling und Normkodierer vorgesehen sind, sind der Übersichtlichkeit halber nicht eingezeichnet.

Wenn der mit dem Analog-Ausgang des Generators 13 verbundene Schalter betätigt wird, arbeitet die Anordnung in gleicher Weise wie die Messanordnung gemäss Fig. 1.

Aus den in dem Speicher abgelegten Daten können die eingangs aufgezählten und in Fig. 7 bis 13 beispielhaft dargestellten Parameter des Prüflings ohne grossen Rechenaufwand und in sehr kurzer Zeit ermittelt werden. Um von speziellen Anfangsbedingungen unabhängig zu sein und die Messung im eingeschwungenen Zustand durchführen zu können, kann die Analyse der Digitalwörter beispielsweise in folgender Weise durchgeführt werden: Der Rechner 7 ermittelt in dem Speicher 5 das erstmalige Auftreten des den höchsten Amplitudenwert beschreibenden Digitalwortes. Dieser Wert wird als Scheitelpunkt des (sinusförmigen) Signals betrachtet. Anschliessend wird unter Zugrundelegung des gegebenen festen Zusammenhanges zwischen Abtast- und Messfrequenz nach dem den kleinsten Amplitudenwert beschreibenden Digitalwort gesucht. Wenn der Prüfling nicht übersteuert ist und unter der Annahme, dass sein Offset-Fehler gleich Null ist, muss das den kleinsten Amplitudenwert beschreibende Digitalwort bei einem Argumentwert erscheinen, der gegenüber dem Argumentwert für den höchsten Amplitudenwert um $\pi/2$ phasenverschoben ist. Ausgehend von diesem Argumentwert wird die tatsächliche Lage des Nulldurchganges ermittelt. Hieraus und aus der Lage des den maximalen Amplitudenwert mit negativem Vorzeichen beschreibenden Digitalwortes lässt sich der Offset-Fehler bestimmen, so dass die charakteristischen Punkte für die in Fig. 6 bzw. 9 dargestellte Kurve fixiert sind.

Abschliessend seien einige Aspekte des Verfahrens gemäss der Erfindung noch einmal kurz zusammengefasst:

Alle Messwerte werden im eingeschwungenen Zustand des Prüflings ermittelt und können aus einer einzigen Messung abgeleitet werden. Aus praktischen Gründen kann es jedoch vorteilhaft sein, an Stelle eines einzigen Messsignals mit einer der Aussteuerungsgrenze des Prüflings entsprechenden Amplitude deren mehrere zu verwenden.

Die Messzeit ist kurz; sie beträgt für die oben angegebenen Werte von Abtast- und Messfrequenz charakteristisch etwa 1 bis maximal 2 s. Bei geeigneter Gestaltung der Messanordnung kann jeweils ein Messvorgang bearbeitet werden, während die nächsten Abtastproben gewonnen werden.

Die Signalantwort des Prüflings entsteht gewissermassen «stroboskopisch». Dadurch können beliebig viele Messpunkte definierter Zeitlage im interessierenden Bereich ermittelt und somit jede gewünschte Auflösung erzielt werden.

Da alle Berechnungen mit solchen mathematischen Operationen durchgeführt werden, die für das gegebene, vorzugsweise sinusförmige, Messsignal bekannt sind, vereinfacht sich die rechnerische Behandlung gegenüber der schnellen Fourier-Transformation ausserordentlich. Aufgrund der exakten zeitlichen Zuordnung ist es nur bei der Berechnung der Quantisierungsverzerrung erforderlich, von Wahrscheinlichkeitsdichten auszugehen.

Wenn das in Fig. 9 dargestellte Diagramm aus den während der Messzeit von z.B. 1 oder 2 s gewonnenen Signalproben zusammengesetzt wird, ergibt sich bei einer Abtastrate von 8 kHz eine Auflösung von z.B. 0,0125 %. Eine derart hohe Auflösung ist jedoch allenfalls in der Nähe des Nulldurchganges erforderlich, während im Bereich der höchsten Amplitude, d.h. in der Nähe der Aussteuerungsgrenze, die Zahl der für die rechnerische Behandlung zu untersuchenden Abtastproben drastisch reduziert werden kann.

Das Verfahren gemäss der Erfindung eignet sich nicht nur für die Prüfung von Analog-Digital- und/oder Digital-Analog-Wandlern, sondern auch für die Prüfung von Gesamtanordnungen, die ausser den Wandlern weitere aktive und/oder passive Übertragungselemente oder -streckenabschnitte beinhalten. Es ist auch möglich, solche Elemente oder Streckenabschnitte separat zu prüfen, wenn das Verhalten der Wandler bekannt ist bzw. zuvor getrennt ermittelt wurde.

Beim Verfahren gemäss der Erfindung entstehen – anders als bei den derzeit üblichen Verfahren – die Schaubilder «pegelabhängige Dämpfungsverzerrung» und «Quantisierungsverzerrung» quasi als geschlossener Kurvenzug, der aus 127 aneinandergefügten Punkten besteht, statt aus z.B. 10 oder 12 Messpunkten, die untereinander durch Geraden verbunden sind, ohne jedoch den dazwischenliegenden tatsächlichen Dämpfungsverlauf darzustellen. Der Zeitaufwand für die Gewinnung der Schaubilder liegt trotzdem etwa bei 1/100 im Vergleich zu den bisher praktizierten Verfahren. Die erforderliche Synchronisation kann auch rechnerisch erfolgen, wenn Messsignal und Taktquelle durch einen Frequenzmesser überwacht werden.

**Patentansprüche**

1. Verfahren zur Prüfung von Analog-Digital-Wandlern und/oder von Digital-Analog-Wandlern oder von nachrichtentechnischen Übertragungsabschnitten, die solche Wandler enthalten oder mit ihnen in Reihe geschaltet sind, insbesondere zur Prüfung von Codecs für PCM-Geräte,

– bei dem von dem Prüfling erzeugte oder beeinflusste Abtastproben eines Messsignals in einem Speicher abgelegt und die interessierenden Parameter durch mathematische Verfahren, z.B. durch Bestimmung der einzelnen Quantisierungsstufen der Übertragungskennlinie durch Regressionsrechnung aus den korrespondierenden Analog- und Digitalwerten, mit Hilfe von Rechnern ermittelt werden,

– wobei ein periodisches Messsignal von einem Signalgenerator erzeugt und dem Analog-Eingang des Prüflings als Analog-Signal zugeführt wird,

– und wobei zur Durchführung der genannten mathematischen Verfahren zumindest ein Teil der in dem Speicher abgelegten Digitalwörter mit den den jeweiligen Abtastwerten zeitlich entsprechenden tatsächlichen Amplitudenwerten des originalen Messsignals in Beziehung gesetzt wird, gekennzeichnet durch folgende Verfahrensschritte

– als Messsignal wird ein vorzugsweise sinusförmiges Signal erzeugt, dessen Periodendauer im Vergleich zu der der Digitalisierung zugrunde liegenden Abtastrate so gewählt ist, dass alle innerhalb eines vorbestimmten sich über eine Vielzahl von Perioden des Messsignals erstreckenden Prüfzeitraumes liegenden Abtastzeitpunkt unterschiedliche relative Zeitlagen innerhalb des Periodizitätsintervalls des Messsignals innehaben,

– alle oder eine Auswahl der am Ausgang des Prüflings unmittelbar auftretenden Digitalwörter (Analog-Digital-Richtung) bzw. der den analogen Ausgangsinformationen des Prüflings entsprechenden mittels eines Normcodierers gewonnenen Digitalwörter (Digital-Analog-Richtung) werden in dem genannten Speicher abgelegt und dem genannten mathematischen Verfahren unterworfen.

2. Verfahren nach Anspruch 1, dadurch gekennzeichnet, dass die Erzeugung des Messsignals, die Abtastung des Prüflings sowie die Einspeicherung der Digitalwörter in den Speicher aus einer gemeinsamen Taktquelle synchronisiert werden.

3. Verfahren nach Anspruch 1 oder 2, dadurch gekennzeichnet, dass die in den genannten Speicher abgelegten Digitalwörter zur Beschreibung des zeitlichen Verlaufs des originalen Messsignals entsprechend ihrer Zeitlage innerhalb des Periodizitätsintervalls des Messsignals sortiert und die ihnen entsprechenden Amplitudenwerte zu einer die Signalantwort des Prüflings auf das Messsignal darstellenden Kurve zusammengesetzt werden.

4. Verfahren nach einem der vorhergehenden Ansprüche, dadurch gekennzeichnet, dass aus den paarweise einander entsprechenden Eingangs-und Ausgangswerten (Analog bzw. -Digital) die tatsächliche Übertragungskennlinie (Fig. 7 und 8) des Prüflings ermittelt wird.

5. Verfahren nach Anspruch 4, dadurch gekennzeichnet, dass aus der Übertragungskennlinie (Fig. 7 und 8) die pegelabhängige Dämpfungsverzerrung (Fig. 10 und 12) des Prüflings ermittelt wird.

6. Verfahren nach Anspruch 4, dadurch gekennzeichnet, dass aus der Übertragungskennlinie (Fig. 7 und 8) des Prüflings dessen pegelabhängige Quantisierungsverzerrung (Fig. 11 und 13) ermittelt wird.

7. Verfahren nach Anspruch 5 und 6, dadurch gekennzeichnet, dass die pegelabhängige Dämpfungs- und Quantisierungsverzerrung für sinusförmige Signale ermittelt werden (Fig. 10 und 11).

8. Verfahren nach Anspruch 5 oder 6, dadurch gekennzeichnet, dass die pegelabhängige Dämpfungs- und Quantisierungsverzerrung für rauschartige Signale ermittelt werden (Fig. 12 und 13).

9. Verfahren nach einem der vorhergehenden Ansprüche, dadurch gekennzeichnet, dass der Prüfling einen Analog-Digital-Wandler und/oder einen Digital-Analog-Wandler sowie einen mit diesem verbundenen Vierpol (z.B. einen Leitungsabschnitt) umfasst.

10. Verfahren nach einem der Ansprüche 1 bis 8, dadurch gekennzeichnet, dass der Prüfling ein Vierpol (z.B. ein Leitungsabschnitt) ist, der mit einem Analog-Digital-Wandler und/oder einem Digital-Analog-Wandler mit bekannten Eigenschaften in Reihe geschaltet ist.

11. Vorrichtung zur Durchführung des Verfahrens nach einem der vorhergehenden Ansprüche, mit einem Generator (2) zur Erzeugung eines analogen periodischen Messsignals, dessen Ausgang mit dem Analog-Eingang des Prüflings (3) verbunden ist, gekennzeichnet durch

– einen mit einem Serien-Parallel-Wandler (4) kombinierten Speicher (5), der mit dem Digital-Ausgang des Prüflings (3) verbunden ist,

– eine Taktquelle (1) zur Synchronisation des Generators (2), des Prüflings (3) und des Speichers (4/5)

– sowie eine Steuereinrichtung (9) zur taktgerechten Ansteuerung des genannten Serien-Parallel-Wandlers (4) und eines in die Verbindung zwischen dem Speicher (5) und dem zur Auswertung vorgesehenen Rechner (7) eingefügten Interface (6).

12. Vorrichtung zur Durchführung des Verfahrens nach einem der Ansprüche 1 bis 10, gekennzeichnet durch

– einen Digitalwort-Generator (10) zur Erzeugung einer das genannte Messsignal beschreibenden digitalen Wortfolge, dessen Ausgang mit dem Digital-Eingang des Prüflings (11) verbunden ist,

– einen Normkodierer (12), dessen Analog-Eingang mit dem Analog-Ausgang des Prüflings (11) verbunden ist,

– einen mit einem Serien-Parallel-Wandler (4) kombinierten Speicher (5), der mit dem Digital-Ausgang des Normkodierers (12) verbunden ist,

– sowie eine Steuervorrichtung (9) zur gemeinsamen Synchronisierung von Generator (10), Prüfling (11), Normkodierer (12) und Speicher (4/5).

13. Vorrichtung nach Anspruch 11, dadurch gekennzeichnet, dass der Generator (2) von dem Analog-Ausgang eines Digital-Analog-Wandlers (14) steuerbar ist, dessen Digital-Eingang die das Messsignal beschreibende digitale Wortfolge eines Digitalwort-Generators (10) zuführbar ist (Fig. 3).

14. Vorrichtung nach einem der Ansprüche 12 oder 13, dadurch gekennzeichnet, dass der Analog-Eingang des Normkodierers (12) über eine Umschalteinrichtung wahlweise mit dem Analog-Ausgang des Prüflings (11) oder dem Analog-Ausgang des Generators (13) und letzerer (13) wahlweise mit dem Analog-Eingang des Prüflings (11) verbindbar ist.

15. Vorrichtung nach einem der Ansprüche 11 bis 14, dadurch gekennzeichnet, dass ein Frequenzmesser zur Überwachung der Synchronisation vorgesehen ist.

**Claims**

1. A method of testing analogue-digital converters and/or digital-analogue converters or telecommunications transmission sections which include such converters or are connected in series thereto, in particular for testing codecs for PCM devices,

– wherein sample specimens of a measurement signal, produced or influenced by the item to be tested, are stored in a store and the parameters of interest are determined by mathematical procedures, e.g. by determining the individual quantisation stages of the transmission curve by regression calculations from the corresponding analogue and digital values, using computers,

– wherein a periodic measurement signal is produced by a signal generator and is fed, as analogue signal, to the analogue input of the item to be tested,

– and wherein, for the implementation of the aforementioned mathematical procedures, at least some of the digital words stored in the store are set in relation to the actual amplitude values of the original measurement signal which correspond in terms to the sample values in question.

characterised by the following steps:

– a preferably sinusoidal signal is produced by way of measurement signal, the period duration of which, compared to the sampling rate on which the digitalisation is based, is selected to be such that all the sampling times which occur within a predetermined test period, which extends over a plurality of periods of the measurement signal, have different relative time positions within the periodicity interval of the measurement signal,

– all or a selection of the digital words which occur directly at the output of the item to be tested (analogue-digital direction), or of the digital words which correspond to the analogue output information of the item to be tested and which are obtained by means of a standard coder (digital-analogue direction) are stored in the aforementioned store and are subjected to the aforementioned mathematical procedure.

2. A method as claimed in claim 1, characterised in that the production of the measurement signal, the sampling of the item to be tested, and the input of the digital words into the store are synchronised from a common clock signal source.

3. A method as claimed in claim 1 or 2, characterised in that the digital words stored in the aforementioned store are sorted in order to describe the time curve of the original measurement signal in accordance with their time position within the periodicity interval of the measurement signal, and the amplitude values corresponding thereto are assembled to form a curve which represents the signal response to the measurement signal of the item to be tested.

4. A method as claimed in one of the preceding claims, characterised in that the actual transmission curve (Fig. 7 and 8) of the item to be tested is determined from the (analogue and digital) input and output values which correspond to one another in pairs.

5. A method as claimed in claim 4, characterised in that the level-dependent attenuation distortion (Fig. 10 and 12) of the item to be tested is determined from the transmission curve (Fig. 7 and 8).

6. A method as claimed in claim 4, characterised in that the level-dependent quantisation distortion of the item to be tested (Fig. 11 and 13) is determined from the transmission curve (Fig. 7 and 8) of the item to be tested.

7. A method as claimed in claim 5 or 6, characterised in that the level-dependent attenuation- and quantisation-distortion is determined for sinusoidal signals (Fig. 10 and 11).

8. A method as claimed in claim 5 or 6, characterised in that the level-dependent attenuation- and quantisation-distortion are determined for noise signals (Fig. 12 and 13).

9. A method as claimed in one of the preceding claims, characterised in that the item to be tested comprises an analogue-digital converter and/or a digital-analogue converter and a four terminal network (e.g. a line section) connected thereto.

10. A method as claimed in one of the claims 1 to 8, characterised in that the item to be tested is a four terminal network (e.g. a line section) which is connected in series to an analogue-digital converter and/or a digital-analogue converter having known characteristics.

11. A device for the implementation of the method claimed in one of the preceding claims, with a generator (2) which serves to produce an analogue, periodic measurement signal and whose output is connected to the analogue-input of the item (3) to be tested, characterised by

– a store (5) which is combined with a series-parallel converter (4) and which is connected to the digital output of the item (3) to be tested,

– a clock signal source (1) which serves to synchronise the generator (2), the item (3) to be tested, and the store (4/5),

– and a control device (9) for the clock-dependent operation of the aforementioned series-parallel converter (4) and an interface (6) which is interposed into the connection between the store (5) and the computer (7) which serves for analysis purposes.

12. A device for the implementation of the method claimed in one of the claims 1 to 10, characterised by

– a digital word generator (10) which serves to produce a digital word sequence descriptive of the aforementioned measurement signal, and whose output is connected to the digital input of the item (11) to be tested,

– a standard coder (12) whose analogue input is connected to the analogue output of the item (11) to be tested,

– a store (5) which is combined with a series parallel converter (4) and which is connected to the digital output of the standard coder (12),

– and a control device (9) for the common synchronisation of generator (10), item (11) to be tested, standard coder (12) and store (4/5).

13. A device as claimed in claim 11, characterised in that the generator (2) can be controlled by the analogue output of a digital-analogue converter (14) whose digital input can be supplied with the digital word sequence, descriptive of the measurement signal, of a digital word generator (10) (Fig. 3).

14. A device as claimed in one of the claims 12 or 13, characterised in that the analogue input of the standard coder (12) can be connected via a switch-over device selectively to the analogue output of the item (11) to be tested or to the analogue output of the generator (13) and said generator (13) can be selectively connected to the analogue input of the item (11) to be tested.

15. A device as claimed in one of the claims 11 to 14, characterised in that a frequency meter is provided in order to monitor the synchronisation.

**Revendications**

1. Procédé pour tester des convertisseurs analogique-numérique et/ou des convertisseurs numérique-analogique, ou des sections de transmission de la technique des communications d'informations contenant de tels convertisseurs ou connectées en série avec eux, en particulier pour tester des codecs pour appareils PCM,

– selon lequel des échantillons d'un signal de mesure produits ou influencés par le dispositif testé sont stockés dans une mémoire et les paramètres d'intérêt sont déterminés à l'aide de calculateurs par des procédés mathématiques, par exemple par détermination des différentes marches de quantification de la caractéristique de transfert par calcul par régression à partir des valeurs analogiques et numériques correspondantes,
– selon lequel un générateur de signal produit un signal de mesure périodique appliqué en tant que signal analogique à l'entrée analogique du dispositif testé et
– selon lequel, pour la mise en œuvre des procédés mathématiques mentionnés, au moins une partie des mots numériques stockés dans la mémoire sont mis en relation avec les valeurs d'amplitude effectives correspondant dans le temps aux valeurs échantillonnées respectives du signal de mesure original,

caractérisé par les pas de procédé suivants

– comme signal de mesure on produit un signal, de préférence sinusoïdal, dont la durée de période est choisie de telle manière, comparativement à la cadence d'échantillonnage sur laquelle est basée la numérisation, que tous les instants d'échantillonnage compris dans un laps de temps d'essai prédéterminé, s'étendant sur un grand nombre de périodes du signal de mesure, présentent différentes positions relatives dans le temps à l'intérieur de l'intervalle de périodicité du signal de mesure et
– on stocke dans ladite mémoire et on soumet audit procédé mathématique la totalité ou une sélection des mots numériques apparaissant directement à la sortie du dispositif testé (sens analogique-numérique), ou des mots numériques correspondant aux informations analogiques à la sortie du dispositif testé et obtenus au moyen d'un codeur normalisé (sens numérique-analogique).

2. Procédé selon la revendication 1, caractérisé en ce que la production du signal de mesure, l'échantillonnage du dispositif testé et le stockage des mots numériques dans la mémoire sont synchronisés à partir d'une source de signaux d'horloge commune.

3. Procédé selon la revendication 1 ou 2, caractérisé en ce que les mots codes stockés dans ladite mémoire sont triés selon leur position dans le temps à l'intérieur de l'intervalle de périodicité du signal de mesure, en vue de la description de l'allure dans le temps du signal de mesure original, et les valeurs d'amplitude correspondant à eux sont assemblées en une courbe représentant la réponse du dispositif testé au signal de mesure.

4. Procédé selon une des revendications précédentes, caractérisé en ce que la caractéristique de transfert effective (Fig. 7 et 8) du dispositif testé est déterminée à partir des valeurs d'entrée et de sortie (analogique respectivement numérique) correspondant par paire l'une à l'autre.

5. Procédé selon la revendication 4, caractérisé en ce que la distorsion d'affaiblissement fonction du niveau (Fig. 10 et 12) du dispositif testé est déterminée à partir de la caractéristique de transfert (Fig. 7 et 8).

6. Procédé selon la revendication 4, caractérisé en ce que la distorsion de quantification fonction du niveau (Fig. 11 et 13) du dispositif testé est déterminée à partir de sa caractéristique de transfert (Fig. 7 et 8).

7. Procédé selon la revendication 5 ou 6, caractérisé en ce que les distorsions d'affaiblissement et de quantification fonction du niveau sont déterminées pour des signaux sinusoïdaux (Fig. 10 et 11).

8. Procédé selon la revendication 5 ou 6, caractérisé en ce que les distorsions d'affaiblissement et de quantification fonction du niveau sont déterminées pour des signaux du type signaux de bruit (Fig. 12 et 13).

9. Procédé selon une des revendications précédentes, caractérisé en ce que le dispositif testé comprend un convertisseur analogique-numérique et/ou un convertisseur numérique-analogique ainsi qu'un quadripôle (par exemple une section de ligne) qui lui est connecté.

10. Procédé selon une des revendications 1 à 8, caractérisé en ce que le dispositif testé est un quadripôle (par exemple une section de ligne) qui est connecté en série avec un convertisseur numérique-analogique de propriétés connues.

11. Dispositif pour la mise en œuvre du procédé selon une des revendications précédentes, comprenant un générateur (2) pour produire un signal de mesure analogique, périodique, dont la sortie est connectée à l'entrée analogique du dispositif testé (3), caractérisé par

– une mémoire (5), combinée avec un convertisseur série-parallèle (4), qui est connectée à la sortie numérique du dispositif testé (3),

– une source de signaux d'horloge (1) pour la synchronisation du générateur (2), du dispositif testé (3) et de la mémoire (4/5),

– ainsi qu'un dispositif de commande (9) pour l'attaque, conformément à la fréquence d'horloge, dudit convertisseur série-parallèle (4) et d'une interface (6) intercalée dans la liaison entre la mémoire (5) et le calculateur (7) prévu pour l'exploitation.

12. Dispositif pour la mise en œuvre du procédé selon une des revendications 1 à 10, caractérisé par

– un générateur de mots numériques (10) destiné à produire une suite de mots numériques décrivant ledit signal de mesure, dont la sortie est connectée à l'entrée numérique du dispositif testé (11),

– un codeur normalisé (12) dont l'entrée analogique est connectée à la sortie analogique du dispositif testé (11),

– une mémoire (5) combinée avec un convertisseur série-parallèle (4), qui est connectée à la sortie numérique du codeur normalisé (12),

– ainsi qu'un dispositif de commande (9) pour la synchronisation commune du générateur (10), du dispositif testé (11), du codeur normalisé (12) et de la mémoire (4/5).

13. Dispositif selon la revendication 11, caractérisé en ce que le générateur (2) peut être commandé par la sortie analogique d'un convertisseur numérique-analogique (14), à l'entrée numérique duquel peut être appliquée la suite de mots numériques, décrivant le signal de mesure, d'un générateur (10) de mots numériques (Fig. 3).

14. Dispositif selon la revendication 12 ou 13, caractérisé en ce que l'entrée analogique du codeur normalisé (12) peut être reliée sélectivement, à travers un dispositif de commutation, à la sortie analogique du dispositif testé (11) ou à la sortie analogique du générateur (13) et que ce dernier peut être relié sélectivement à l'entrée analogique du dispositif testé (11).

15. Dispositif selon une des revendications 11 à 14, caractérisé en ce qu'un fréquencemètre est prévu pour surveiller la synchronisation.

# FIG 1

# FIG 2

# FIG 3

## FIG 4

## FIG 5

## FIG 6

# FIG 7

UEBERTRAGUNGSKENNLINIE

Bildgrenze
1.0000

PCM

Analog

-10.46        -3.10 dBm0

# FIG 8

UEBERTRAGUNGSKENNLINIE

Bildgrenze
.0500

PCM

Analog

-10.46        -3.10 dBm0

15

FIG 9

# FIG 10

[db]

PEGELABHAENGIGE DAEMPFUNGSVERZERRUNG A-D

1.5

1

.5

.3

[dbm0]

-1

-50    -40    -30    -20    -10    0

# FIG 11

[db]

PEGELABHAENGIGE QUANTISIERUNGSVERZERRUNG A-D

40

30

20

10

-50    -40    -30    -20    -10    0 [dbm0]

19

# FIG 12

[db]

PEGELABHAENGIGE DAEMPFUNGSVERZERRUNG A-D

# FIG 13

[db]

PEGELABHAENGIGE QUANTISIEPUNGSVERZERRUNG A-D